# FASCICULE DE BREVET EUROPEEN

(11) **EP 4 627 629 B1**
(45) Date de publication et mention de la délivrance du brevet: **04.11.2026**
(21) Numéro de dépôt: 23814417.4
(22) Date de dépôt: 29.11.2023
(51) Int. Cl.: H10H 29/01

(54) **PROCÉDÉ DE FABRICATION D'UN DISPOSITIF OPTOÉLECTRONIQUE**
VERFAHREN ZUR HERSTELLUNG EINER OPTOELEKTRONISCHEN VORRICHTUNG
METHOD FOR PRODUCING AN OPTOELECTRONIC DEVICE

(30) Priorité: 02.12.2022 FR 2212706
(43) Date de publication de la demande: 08.10.2025
(73) Titulaire: Aledia, 38800 Champagnier (FR)
(72) Inventeur: MAYER, Frédéric, 38430 Moirans (FR)
(74) Mandataire: Hautier IP
(86) Numéro de dépôt international: PCT/EP2023/083449
(87) Numéro de publication internationale: WO 2024/115528

(56) Documents cités:
- EP-A1- 3 401 958
- EP-A1- 4 092 746
- WO-A1-2022/017972
- FR-A1- 3 023 066
- FR-A1- 3 077 653
- FR-A1- 3 114 685
- US-A1- 2017 358 562
- US-A1- 2020 194 417
- US-A1- 2020 403 117

## Description

### DOMAINE TECHNIQUE

La présente invention concerne le domaine des technologies pour l'optoélectronique. Elle trouve pour application particulièrement avantageuse le test et la fabrication de dispositifs optoélectroniques comprenant une électronique de pilotage, par exemple des pixels intelligents ou « smart pixels » à base de diodes électroluminescentes.

### ETAT DE LA TECHNIQUE

Un écran d'affichage auto-émissif est un exemple de système optoélectronique connu. Un tel écran comprend une pluralité de pixels émettant leur propre lumière. Chaque pixel est ainsi typiquement formé par une ou plusieurs LEDs ou micro-LEDs. Chaque LED peut être pilotée individuellement grâce à une électronique de commande issue de la technologie CMOS (technologie basée sur l'utilisation de transistors métal-oxyde-semiconducteur (MOS) complémentaires). Une LED associée à son électronique de commande est typiquement appelée smart LED. Un pixel comprenant plusieurs LED associées à au moins une électronique de commande est appelé smart pixel.

La structure résultant de l'association de LED avec une électronique de commande s'apparente à un empilement vertical comprenant un étage optiquement actif à base de LED surmontant un étage de commande à base de composants électroniques, les LED et les composants électroniques étant interconnectés par des connexions électriques entre des zones de contact de l'étage de commande, appelées CMOS pads, et des zones de contact de l'étage optiquement actif.

Il arrive que l'étage de commande soit défaillant, par exemple lorsque certains composants électroniques présentent des défauts ou des performances sub-nominales. Pour éviter de fabriquer des smart LED ou smart pixels défectueux, un test préalable de l'électronique de commande est souhaitable. Une telle étape de test préalable permet typiquement de limiter les coûts de réparation ultérieurs, lors de la fabrication de l'écran d'affichage par exemple.

L'étage optiquement actif, appelé par concision étage optique, est d'abord en partie formé sur un substrat dédié, par des premières étapes de fabrication. Ces premières étapes de fabrication comprennent notamment la formation des LED et la formation de connexions et de zones de contact pour ces LED, au niveau d'une face dite de connexion de l'étage optique.

Les composants électroniques de l'étage de commande sont typiquement formés sur un substrat silicium en « face avant ». Les interconnexions et les pads de contact de l'étage de commande sont également formés en face avant.

Lors de l'association de l'étage de commande à l'étage optique, cette face avant est mise en regard de la face de connexion portant les zones de contact des LED. Un collage est ensuite effectué entre ces deux faces. Le substrat silicium est alors retiré et des vias de contact traversant sont formés depuis la « face arrière » de l'étage de commande vers la face avant. Des plots de contact en face arrière sont alors réalisés. Ces plots de contact en face arrière permettent de tester les composants électroniques de l'étage de commande, en posant typiquement des pointes de test sur ces plots de contact.

Cette solution permet de préserver un état de surface de la face avant compatible avec le collage direct. Les pointes de contact sont en effet connues pour générer une rugosité importante, jusqu'à environ 3 µm pic-à-pic, rendant difficile et onéreux une étape de collage direct ultérieure au niveau de la face testée.

Un inconvénient de cette solution est que le test des composants électroniques de l'étage de commande survient après collage. Lorsque l'étage de commande testé s'avère défaillant, il est difficile voire impossible de le séparer de l'étage optique auquel il est associé. Cela rend le procédé de fabrication des smart LED ou smart pixels long, complexe et coûteux.

FR 3077653 A1, EP 4092746 A1, EP 3401958 A1, FR 3114685 A1, WO 2022/017972 A1, FR 3023066 A1, US 2017/358562 A1, US 2020/194417 A1 et US 2020/403117 A1 divulguent des procédés de fabrication d'un dispositif optoélectronique comportant une partie de commande et une partie optiquement active.

La présente invention vise à pallier au moins partiellement le ou les inconvénients des solutions mentionnées ci-dessus.

En particulier, un objet de la présente invention est de proposer un procédé de fabrication d'un dispositif optoélectronique comprenant un étage optique et un étage de commande associés. Selon un objet, ce procédé de fabrication permet de tester l'étage de commande séparément de l'étage optique et/ou préalablement à l'association des étages optique et de commande. Un autre objet de la présente invention est de proposer un procédé de fabrication d'un dispositif optoélectronique dont la durée et/ou le coût sont diminués. Un autre objet de la présente invention est de proposer un tel dispositif optoélectronique.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du procédé de fabrication peuvent s'appliquer mutatis mutandis au dispositif optoélectronique, et réciproquement.

### RESUME

Pour atteindre les objectifs mentionnés ci-dessus, l'invention concerne un procédé de fabrication d'un dispositif optoélectronique selon la revendication 1.

Ainsi, le procédé permet avantageusement de retourner la partie de commande pour la connecter en face arrière avec la partie optique, via les connexions électriques traversantes. Les avantages issus de l'architecture particulière du dispositif, énoncés ci-dessus, s'appliquent au procédé. Ainsi, le test en face avant de la partie de commande est envisageable dès la fourniture de la partie de commande, avant tout assemblage ou collage de la partie de commande avec la partie optique. Le test en face avant de la partie de commande peut encore se faire après assemblage, typiquement après retrait du substrat de transfert.

Par ailleurs, dans un procédé de fabrication classique de smart pixel, comme la face avant de la partie de commande sert au collage et à l'interfaçage électrique avec la partie optique, c'est la face arrière qui est dédiée au test de la partie de commande. Des connexions électriques traversantes sont généralement créées depuis la face arrière jusqu'au niveau d'interconnexions électriques de la partie de commande, après collage avec la partie optique. Le collage en face avant se fait au plus tôt afin de préserver la face avant d'éventuels dommages causés par d'autres étapes de manipulation. Les étapes de collage puis de formation des connexions électriques traversantes sont ainsi effectuées en série. Cela rend le procédé de fabrication classique long, avec le risque de déceler trop tardivement d'éventuels dysfonctionnements de la partie de commande.

Au contraire, selon le procédé de la présente invention, les connexions électriques traversantes de la partie de commande sont formées avant collage avec la partie optique. Il est donc possible de traiter la partie de commande et la partie optique séparément, en parallèle. Un traitement parallèle permet d'optimiser le temps d'équipement sur une chaîne de fabrication. La durée du procédé de fabrication est ainsi diminuée. Le nombre d'étapes ultérieures au collage des parties optique et de commande est réduit.

Des applications avantageuses particulières du dispositif optoélectronique et du procédé de fabrication concernent le domaine des smart LED et des smart pixels.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

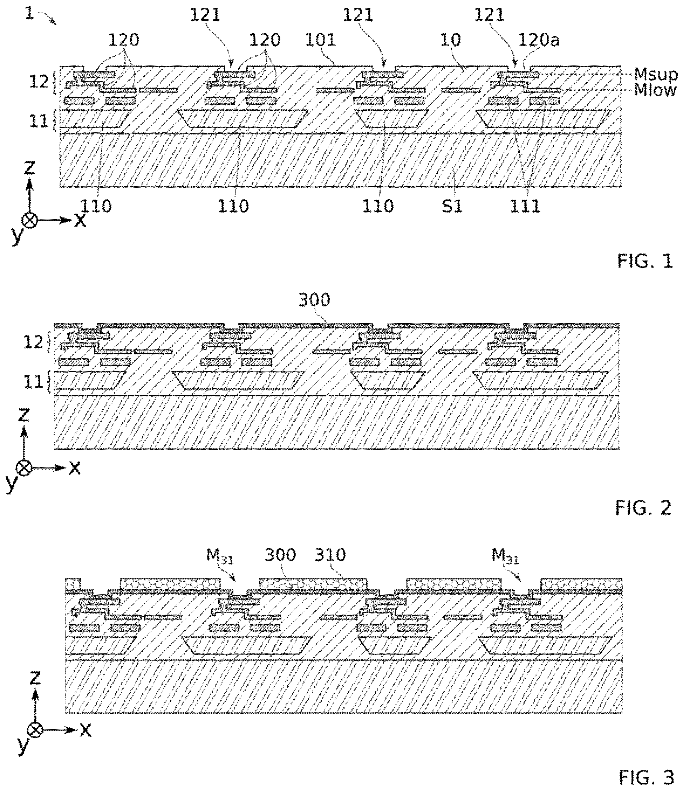

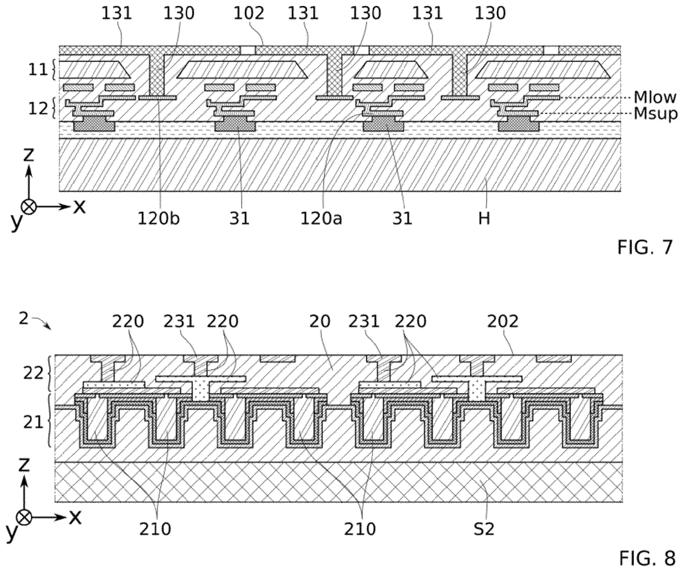

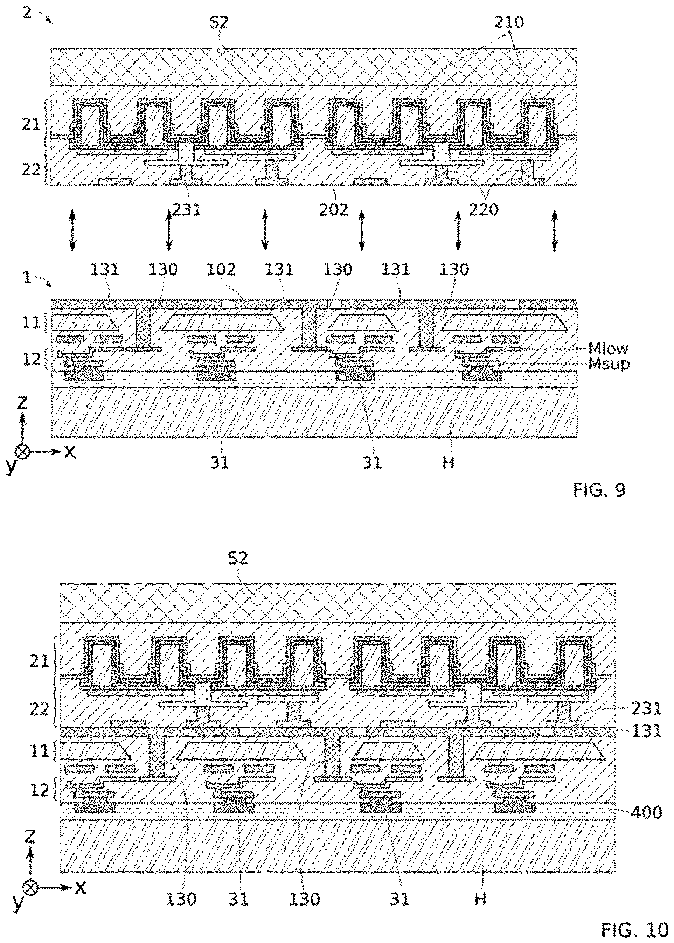

Les figures 1 à 12 illustrent schématiquement des étapes de fabrication d'un dispositif optoélectronique selon un mode de réalisation de la présente invention. Les figures 1 à 7 illustrent schématiquement des étapes de fabrication d'une partie de commande d'un dispositif optoélectronique selon un mode de réalisation de la présente invention. La figure 8 illustre schématiquement une partie optique d'un dispositif optoélectronique selon un mode de réalisation de la présente invention. Les figures 9 à 12 illustrent schématiquement des étapes d'assemblage d'une partie de commande avec une partie optique d'un dispositif optoélectronique selon un mode de réalisation de la présente invention.

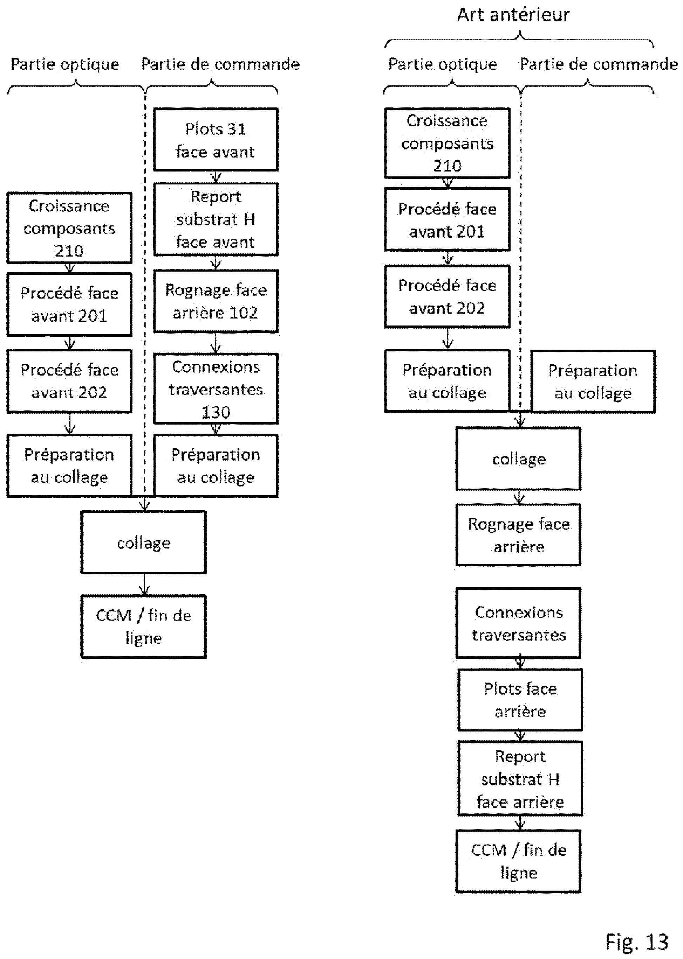

La figure 13 illustre sous forme d'organigrammes un enchaînement d'étapes du procédé selon un mode de réalisation de la présente invention et un enchaînement d'étapes d'un procédé classique, selon l'art antérieur.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différentes parties des structures de test et de transfert et des LED ne sont pas forcément représentatives de la réalité.

### DESCRIPTION DÉTAILLÉE

Avant d'entamer une revue détaillée de modes de réalisation de l'invention, il est rappelé que l'invention comprend notamment les caractéristiques optionnelles ci-après pouvant être utilisées en association ou alternativement :
Selon un exemple, la face avant de la partie de commande présente des plots de contact en saillie, destinés à être contactés par des pointes de test, lesdits plots de contact étant connectés au niveau d'interconnexions électriques. Ces plots de contact sont typiquement dimensionnés de façon à supporter le contact et la pression exercés par des pointes de test classiquement utilisées pour le test électrique. Ces plots de contact sont de préférence spécifiquement prévus pour effectuer un tel test électrique, contrairement aux interconnexions et/ou pads de contact du niveau d'interconnexions de la partie de commande.

Selon un exemple, selon la direction z d'empilement, le dispositif comprend successivement : la face avant de la partie de commande, le niveau d'interconnexions de la partie de commande, le niveau de composants électroniques de la partie de commande, la face arrière de la partie de commande, la face de connexion de la partie optique, le niveau de connexions de la partie optique, le niveau de composants optiquement actifs de la partie optique. Dans cet empilement, la partie de commande est typiquement retournée par rapport à une partie de commande d'un dispositif de type smart pixel standard. Les faces avant et arrière de la partie de commande sont ainsi interverties par rapport à une configuration standard.

Selon un exemple, les composants optiquement actifs de la partie optique sont des diodes électroluminescentes à base de GaN.

Selon un exemple, les composants électroniques de la partie de commande comprennent des transistors, par exemple des transistors MOS ou des transistors de type TFT (signifiant « Thin Film Transistors » soit transistors en couche mince).

Selon un exemple, le procédé de fabrication comprend en outre une formation de plots de contacts en saillie de la face avant et connectés au niveau d'interconnexions, lesdits plots de contact étant destinés à être contactés par des pointes de test.

Selon un exemple, les plots de contact sont formés dans des ouvertures de la face avant, lesdites ouvertures débouchant sur des pistes métalliques supérieures du niveau d'interconnexions. Le niveau d'interconnexions comprend typiquement une pluralité de pistes métalliques en empilement selon z. Dans un tel empilement, les pistes métalliques supérieures se trouvent typiquement au plus proche de la face avant, à l'opposé des composants électroniques, selon z. Les plots de contact en face avant sont ainsi connectés à ces pistes métalliques supérieures. Selon un exemple, la formation des plots de contact comprend un dépôt pleine plaque d'une couche de germination, une étape de lithographie définissant, dans une couche de résine, des motifs de contact à l'aplomb des ouvertures de la face avant, un remplissage desdits motifs de contact par un premier matériau métallique ou une première pluralité de matériaux métalliques, par exemple Cu/Ni/Au ou Cn/Ni/SnAg, un retrait de la couche de résine exposant des parties de la couche de germination, en dehors des motifs de contact, et un retrait des parties exposées de la couche de germination.

Selon un exemple, la formation des plots de contacts est effectuée avant collage de la partie de commande sur le substrat de transfert.

Selon un exemple alternatif, la formation des plots de contacts est effectuée après collage de la partie de commande sur le substrat de transfert, et après un retrait du substrat de transfert,

Selon un exemple, le procédé de fabrication comprend en outre une étape de test de la partie de commande en connectant des pointes de test sur les plots de contact ou sur des pistes métalliques supérieures (120a, Msup) du niveau (12) d'interconnexions. Cette étape de test est de préférence effectuée avant collage de la face arrière de la partie de commande avec la face de connexion de la partie optique. Cela permet de stopper le procédé de fabrication avant collage en cas de partie de commande défectueuse ou dysfonctionnelle. A ce stade, la partie de commande dysfonctionnelle peut être remplacée par une autre partie de commande fonctionnelle en vue du collage avec la partie optique. L'impact sur les coûts du procédé de fabrication est ainsi limité.

Selon un exemple, le collage de la partie de commande sur le substrat de transfert se fait par intercalation d'une couche entre la face avant de la partie de commande et le substrat de transfert ladite couche étant à base d'un matériau organique ou minéral. La couche polymère permet typiquement d'absorber une topographie au niveau de la face avant, en particulier la topographie due à la présence de plots de contact en saillie de la face avant. La couche minérale permet de supporter un budget thermique plus important. Elle permet également de limiter la contamination. Selon un exemple, le procédé de fabrication comprend en outre, après retrait du deuxième substrat, une formation de modules de conversion de couleur à partir de la face d'émission ou de réception de la partie optique, lesdits modules de conversion de couleur étant configurés pour modifier une longueur d'onde du rayonnement lumineux émis ou reçu par les composants optiquement actifs.

Selon un exemple, le procédé de fabrication comprend en outre, après formation des modules de conversion de couleur, une formation ou un collage d'une couche transparente protectrice sur lesdits modules de conversion de couleur. La couche transparente protectrice permet de protéger et/ou manipuler les plaques portant les dispositifs.

Selon un exemple, la formation des connexions électriques traversantes comprend une formation par lithographie et gravure, depuis la face arrière, de motifs de vias exposant des pistes métalliques inférieures du niveau d'interconnexions, lesdites pistes métalliques inférieures étant de préférence situées du côté des composants électroniques, et un remplissage desdits motifs de vias par un deuxième matériau métallique. Le niveau d'interconnexions comprend typiquement une pluralité de pistes métalliques en empilement selon z. Dans un tel empilement, les pistes métalliques inférieures se trouvent typiquement au plus proche des composants électroniques, à l'opposé de la face avant, selon z. Les connexions électriques traversantes en face arrière sont ainsi connectées à ces pistes métalliques inférieures.

Selon un exemple, la face de connexion de la partie optique comprend des deuxièmes zones de contact.

Selon un exemple, le procédé de fabrication comprend en outre une formation de premières zones de contacts sur la face arrière de la partie de commande, lesdites premières zones de contact reliant au moins certaines connexions électriques traversantes, lesdites premières zones de contact étant configurées pour être assemblées par un collage métal-métal ou par un collage direct hybride avec les deuxièmes zones de contact de la face de connexion de la partie optique. Sauf incompatibilité, des caractéristiques techniques décrites en détail pour un mode de réalisation donné peuvent être combinées aux caractéristiques techniques décrites dans le contexte d'autres modes de réalisation décrits à titre exemplaire et non limitatif, de manière à former un autre mode de réalisation qui n'est pas nécessairement illustré ou décrit. Un tel mode de réalisation n'est évidemment pas exclu de l'invention.

Dans la présente invention, le procédé est en particulier dédié au test des parties de commande de dispositifs optoélectroniques, en particulier de diodes électroluminescentes (LED), et notamment de smart LEDs ou smart pixels. Les LEDs présentes dans les smart pixels présentent typiquement des dimensions, en projection dans un plan de base xy, comprises entre 10 µm X 10 µm et 300 µm X 300 µm.

L'invention peut être mise en œuvre plus largement pour différents dispositifs optoélectroniques, voire pour des dispositifs ou microsystèmes électromécaniques MEMS. L'invention peut par exemple être mise en œuvre dans le cadre de dispositifs laser ou photovoltaïque. D'autres composants optoélectroniques sont parfaitement envisageable, notamment pour la réalisation de micro-écrans. Ces composants peuvent présenter des dimensions plus grandes, de l'ordre du centimètre.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément. Ainsi, les termes et locutions « prendre appui » et « couvrir » ou « recouvrir » ne signifient pas nécessairement « au contact de ».

Les étapes du procédé telles que revendiquées s'entendent au sens large et peuvent éventuellement être réalisées en plusieurs sous-étapes.

Dans la présente demande de brevet, les termes « diode électroluminescente », « LED » ou simplement « diode » sont employés en synonymes. Une « LED » peut également s'entendre d'une « micro-LED » ou d'une « mini-LED », voire d'un « micro-écran ». On parlera de smart LED lorsqu'une LED est associée à une partie de commande.

On entend par « composant optiquement actif » un composant capable de recevoir ou d'émettre de la lumière, et/ou de transformer les propriétés de la lumière. Les diodes et les lasers sont des exemples de composants optiquement actifs. Les cellules photovoltaïques sont d'autres exemples de composants actifs. Les modulateurs de phase photoniques sont également d'autres exemples de composants actifs. Ces exemples ne sont pas limitatifs.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une diode à base de GaN comprend typiquement du GaN et des alliages d'AlGaN ou d'InGaN.

Un repère, de préférence orthonormé, comprenant les axes x, y, z est représenté sur certaines figures annexées. Ce repère est applicable par extension aux autres figures d'une même planche de figures.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base xy. Ainsi, une couche présente typiquement une épaisseur selon z, lorsqu'elle s'étend principalement le long d'un plan xy, et un élément en saillie, par exemple un plot de contact, présente une hauteur selon z. Les termes relatifs « sur », « sous », « sous-jacent » se réfèrent préférentiellement à des positions prises selon la direction z.

Les valeurs dimensionnelles s'entendent aux tolérances de fabrication et de mesure près.

Les termes « sensiblement », « environ », « de l'ordre de » signifient, lorsqu'ils se rapportent à une valeur, « à 10% près » de cette valeur ou, lorsqu'ils se rapportent à une orientation angulaire, « à 10° près » de cette orientation. Ainsi, une direction sensiblement normale à un plan signifie une direction présentant un angle de 90+10° par rapport au plan.

La figure 1 illustre une partie de commande 1 classiquement utilisée pour des dispositifs optoélectroniques de type smart LED ou smart pixels. Cette partie de commande 1 comprend ainsi typiquement un niveau 11 de composants électroniques 110 surmontés par un niveau 12 d'interconnexions électriques 120.

Le niveau 11 peut notamment correspondre à un niveau dit de début de ligne FEOL (acronyme de « Front End Of Line ») et les composants électroniques 110 peuvent par exemple comprendre des transistors CMOS, par exemple sous forme de microcircuits intégrés µIC. Un tel niveau 11 est généralement formé directement sur un substrat S1 à base de silicium, par exemple un substrat massif en silicium ou un substrat en silicium sur isolant SOI (acronyme de « Silicon On Insulator »). Le niveau 11 peut alternativement comprendre des transistors en couches minces TFT (acronyme de « Thin Film Transistor »).

Le niveau 12 peut notamment correspondre à un niveau dit de fin de ligne BEOL (acronyme de « Back End Of Line ») et les interconnexions électriques 120 peuvent par exemple comprendre des pistes métalliques sensiblement horizontales et des vias verticaux reliant ces pistes métalliques. Les interconnexions électriques 120 sont typiquement formées au sein d'une matrice 10 en un matériau diélectrique. Dans l'empilement, les interconnexions électriques 120 sont généralement distribuées selon z sur plusieurs niveaux appelés niveaux de métal 1 à N. Ainsi, un premier niveau de pistes métalliques inférieures Mlow est situé du côté des composants électroniques 110, au plus près de ces composants 110 ou d'un niveau de contacts 111 surmontant les composants 110. Un dernier niveau de pistes métalliques supérieures Msup est situé du côté de la face avant 101.

Des ouvertures 121 sont typiquement formées depuis la face avant 101, à l'aplomb des pistes métalliques supérieures 120a. Les ouvertures 121 débouchent sur lesdites pistes métalliques supérieures 120a. Ces ouvertures 121 vont permettre la formation de plots de contact connectés au niveau 12 d'interconnexions 120.

Les figures 2 à 5 illustrent des étapes de formation de ces plots de contact dans les ouvertures 121.

Comme illustré à la figure 2, une couche de germination 300 est de préférence déposée de façon conforme sur la face avant 101 et dans les ouvertures 121. Cette couche de germination 300 est typiquement à base de cuivre. Elle peut se présenter sous la forme d'une bicouche ou d'une tri-couche comprenant par exemple une couche d'accroche à base de titane, une couche barrière optionnelle à base de TiN, et une couche de cuivre pour la germination. Elle est de préférence de faible épaisseur, par exemple de l'ordre de quelques dizaines à quelques centaines de nanomètres, et tapisse le fond et les parois des ouvertures 121. Le dépôt de cette couche de germination 300 peut se faire par dépôt électrolytique ECD (Electro Chemical Deposition selon l'acronyme anglo-saxon), par dépôt chimique en phase vapeur (CVD selon l'acronyme anglo-saxon) ou par dépôt physique en phase vapeur (PVD selon l'acronyme anglo-saxon), de façon à obtenir un germe de bonne qualité cristalline.

Comme illustré à la figure 3 après le dépôt pleine plaque de la couche de germination 300, une couche de résine 310 est déposée puis structurée par lithographie de façon à définir des motifs de contact M31 à l'aplomb des ouvertures 121. La couche de germination 300 est exposée au niveau de ces motifs de contact M31.

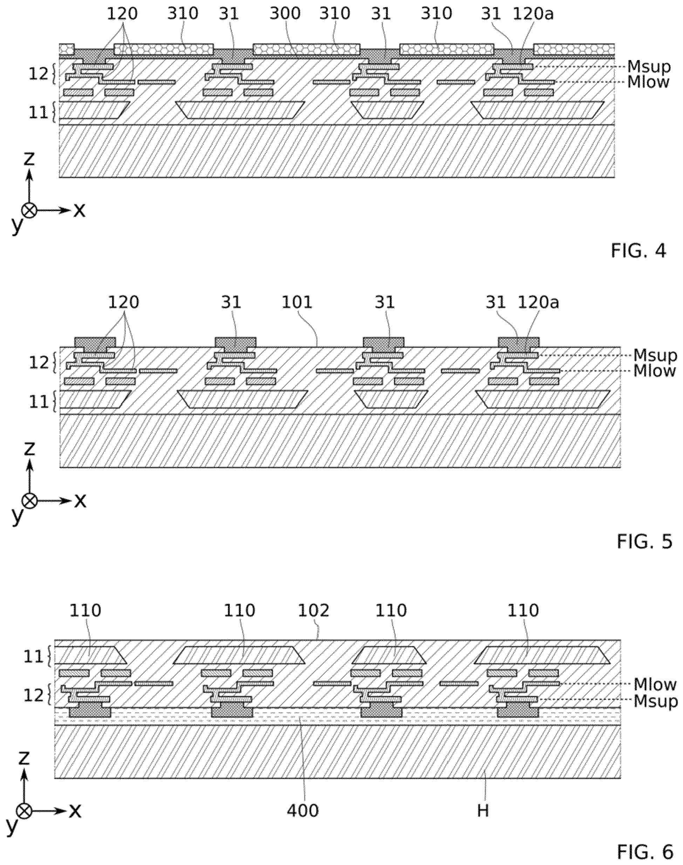

Comme illustré à la figure 4, les motifs de contact M31 sont ensuite remplis par croissance d'un ou plusieurs matériaux métalliques, typiquement par des multicouches Cu/Ni/Au ou Cu/Ni/SnAg, pour former les plots de contact 31. Le remplissage peut se faire par dépôt électrolytique ECD de façon à obtenir une épaisseur de métal plus importante pour les plots de contact 31, par exemple de l'ordre de quelques microns. Une telle épaisseur de plot de contact 31 permet notamment de supporter un contact avec des pointes de test sans endommager les pistes métalliques supérieures 120a du niveau 12 d'interconnexions 120 sous-jacent.

Comme illustré à la figure 5, la couche de résine 310 peut ensuite être retirée, par exemple par un retrait chimique, à température ambiante ou en température (< 100°C). Les parties de la couche de germination 300 initialement masquées par la couche de résine 310 sont ainsi exposées. Ces parties exposées de la couche de germination 300 sont alors retirées, par exemple par gravure humide, afin d'isoler les plots de contact 31 entre eux (figure 5). A l'issue de ces étapes de formation des plots de contact 31, les plots de contact 31 sont typiquement en saillie de la face avant 101. A ce stade, la partie de commande peut être avantageusement testée via les plots de contact 31 en face avant 101. Un module de test externe doté de pointes de test peut être connecté aux plots de contact 31. Si le test révèle un dysfonctionnement de cette partie de commande, le procédé de fabrication est arrêté avant assemblage avec la partie optique. Les coûts sont diminués. Le remplacement de la partie de commande défectueuse est facilité. Si le résultat du test est positif, c'est-à-dire si la partie de commande est fonctionnelle ou suffisamment fonctionnelle (par exemple si le rendement est suffisant), le procédé de fabrication est poursuivi. Comme illustré à la figure 6, la partie de commande sur son substrat S1 est alors retournée et collée sur un substrat de transfert H. Le collage peut se faire par l'intermédiaire d'une couche de collage 400 à base de polymère. Cela permet d'accommoder la topographie en face avant 101 due à la présence des plots de contact 31, le cas échéant. Alternativement, le collage entre la partie de commande et le substrat de transfert H peut se faire par l'intermédiaire d'une couche de collage 400 minérale, typiquement à base d'oxyde de silicium. Une telle couche de collage 400 minérale permet de supporter des températures plus élevées qu'une couche organique. Une couche de collage 400 minérale permet également de gérer plus facilement les problématiques liées à la contamination, à la fois au sein des équipements impliqués dans le procédé de fabrication, et sur le dispositif en cours de fabrication, notamment lors du retrait du substrat de transfert H. Ce type de collage « minéral » peut se faire avant ou après la formation des plots de contact 31, de préférence avant la formation des plots de contact 31.

Selon une possibilité alternative, les plots de contact 31 sont réalisés uniquement à la fin du procédé de fabrication. Les étapes illustrées aux figures 2 à 5 sont effectuées ultérieurement, typiquement après retrait du substrat de transfert H. Cela permet de faciliter la réalisation d'un collage minéral entre la face avant 101 de la partie de commande et le substrat de transfert H. Cela n'empêche pas le test de la partie de commande car celui-ci peut être fait notamment avec des pointes directement sur les pistes métalliques supérieures 120a. Les défauts de planéité engendrés par ce test peuvent être gommés ultérieurement lors des étapes de réalisation des plots 31 (figures 2 à 5), en fin de procédé.

Après collage du substrat de transfert H, que ce soit par l'intermédiaire d'une couche de collage 400 organique ou minérale, le substrat S1 est retiré, par exemple par rognage. La face arrière 102 de la partie de commande est ainsi exposée.

Comme illustré à la figure 7, des connexions électriques traversantes 130, par exemple sous forme de vias, sont formés depuis la face arrière 102 jusqu'au niveau 12 d'interconnexions électriques 120. Les connexions électriques traversantes 130 traversent typiquement le niveau 11 de composants électroniques 110, selon z. Elles sont de préférence connectées à des pistes métalliques inférieures 120b du premier niveau de métal Mlow, à l'opposé des pistes métalliques supérieures 120a du dernier niveau de métal Msup connectées aux plots de contact 31. Les connexions électriques traversantes 130 ou vias peuvent être formées par photolithographie et gravure au travers de la matrice 10 diélectrique, selon des procédés standards de la microélectronique. Si les connexions électriques traversantes 130 traversent un matériau conducteur ou semiconducteur, par exemple une couche mince semiconductrice utilisée pour former des composants électroniques 110 selon une technologie PDSOI (acronyme de « Partially Depleted Silicon On Insulator ») ou FDSOI (acronyme de « Fully Depleted Silicon On Insulator »), ces connexions électriques traversantes 130 peuvent être isolées par une gaine isolante.

Des zones de contacts 131 sont ensuite formées sur la face arrière 102. Un dépôt PVD métallique, par exemple successivement à base de cuivre et de titane, est typiquement effectué en face arrière 102 puis structuré par photolithographie et gravure pour former ces zones de contact 131 de la partie de commande. Les zones de contact 131 sont configurées pour connecter les connexions électriques traversantes 130. Elles sont destinées à relier électriquement la partie optique du dispositif optoélectronique lors de l'assemblage de la partie de commande avec la partie optique.

Selon une possibilité alternative, les zones de contact 131 sont formées de la même manière que les plots de contact 31, avec un dépôt préalable d'une couche de germination puis une recharge localisée de métal par photolithographie et dépôt électrochimique, puis un retrait partiel de la couche de germination, en dehors des zones de contact 131.

La partie de commande 1 est typiquement configurée pour commander ou piloter la partie optique 2.

Comme illustré à la figure 8, la partie optique 2 est fabriquée indépendamment de la partie de commande 1. Cette partie optique 2 comprend ainsi typiquement un niveau 21 de composants optiquement actifs 210 surmontés par un niveau 22 de connexions électriques 220.

Le niveau 21 peut notamment comprendre des diodes électroluminescentes, de préférence des µLED ou des LED à base de nanofils. Un tel niveau 21 est généralement formé directement sur un substrat initial spécifique, par exemple à base de silicium ou de saphir (non illustré), puis transféré sur un substrat S2 afin de former le niveau 22 de connexions électriques 220 en « face arrière » du niveau 21 de composants optiquement actifs 210 après retrait du substrat initial.

Le niveau 22 peut notamment comprendre des connexions électriques 220 sous forme de pistes métalliques sensiblement horizontales et de vias verticaux reliant ces pistes métalliques. Les connexions électriques 220 sont typiquement formées au sein d'une matrice 20 en un matériau diélectrique. Des plots ou des zones de contact 231 destinées à relier électriquement la partie de commande du dispositif optoélectronique lors de l'assemblage de la partie optique avec la partie de commande, sont typiquement prévues au niveau d'une face 202 dite de connexion de la partie optique 2.

Selon une possibilité, les zones de contact 231 sont formées de la même manière que les plots de contact 31, avec un dépôt préalable d'une couche de germination puis une recharge localisée de métal par photolithographie et dépôt électrochimique, puis un retrait partiel de la couche de germination, en dehors des zones de contact 231.

Avantageusement, la partie de commande 1 illustrée à la figure 7 et la partie optique 2 illustrée à la figure 8 sont fabriquées en parallèle l'une de l'autre, c'est-à-dire potentiellement sensiblement en même temps. Cela permet de diminuer la durée totale du procédé de fabrication du dispositif optoélectronique. Cela permet d'optimiser l'utilisation des équipements industriels de fabrication. Selon une possibilité, les zones de contact 131 et les zones de contact 231 sont formées simultanément et/ou dans un même équipement selon un même procédé, typiquement en effectuant des dépôts pleine plaque sur les faces 102, 202, suivis de structurations par photolithographies et gravures, et/ou de polissage mécano-chimique CMP (acronyme de « Chemical Mechanical Polishing »). Cela permet d'optimiser l'utilisation des équipements et de réduire la durée du procédé de fabrication.

Selon une possibilité, les plots de contact 31 et les zones de contact 231 sont formés simultanément et/ou dans un même équipement selon un même procédé, typiquement en effectuant des dépôts pleine plaque sur les faces 101, 202, suivis de structurations par photolithographies et gravures. Cela permet d'optimiser l'utilisation des équipements et de réduire la durée du procédé de fabrication.

Comme illustré à la figure 9, la face de connexion 202 de la partie optique 2 est ensuite mise en regard de la face arrière 102 de la partie de commande 1, en vue de l'assemblage de la partie optique 2 avec la partie de commande 1. Les zones de contact 231 sont typiquement alignées avec les zones de contact 131.

Comme illustré à la figure 10, la partie optique 2 et la partie de commande 1 sont alors assemblées, par exemple par collage direct hybride, par thermocompression ou par collage eutectique métal-métal, au niveau des faces 102, 202, au moins en partie par l'intermédiaire des zones de contact 131, 231.

A ce stade, l'empilement comprend successivement selon z : le substrat de transfert H, la couche de collage 400 polymère ou oxyde, les plots de contact 31, le niveau 12 d'interconnexions électriques, le niveau 11 de composants électroniques, les zones de contact 131 de la partie de commande, les zones de contact 231 de la partie optique, le niveau 22 de connexions électriques, le niveau 21 de composants optiquement actifs, le substrat S2.

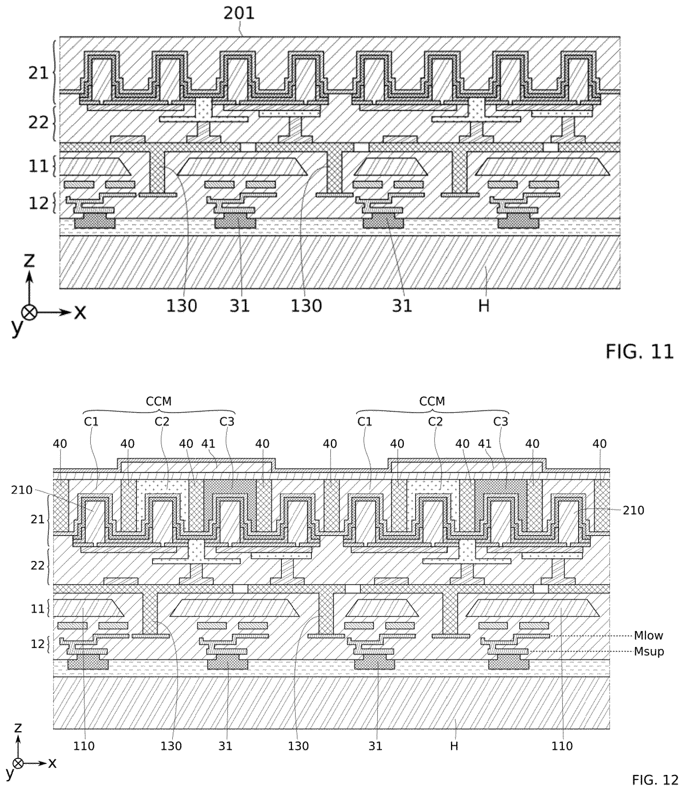

Comme illustré à la figure 11, le substrat S2 peut alors être retiré, par exemple pas rognage, afin d'exposer la « face avant » de la partie optique, typiquement une face 201 d'émission ou de réception de la lumière.

Comme illustré à la figure 12, un module de conversion de couleur CCM peut ensuite être formé au niveau des composants optiquement actifs, à partir de la face 201. De façon connue, un tel module est configuré pour convertir une lumière émise selon une longueur d'onde initiale par les composants optiquement actifs 210, en lumière présentant une ou plusieurs longueurs d'onde différentes, typiquement des première, deuxième et troisième longueurs d'onde correspondant aux couleurs bleu (B), vert (V) et rouge (R). Cela permet de former des sous-pixels RVB d'un pixel d'un écran d'affichage par exemple. Un tel module CCM est typiquement formé par dépôt localisé de différentes nanoparticules C1, C2, C3 sur différents composants optiquement actifs 210 destinés à former les sous-pixels. Les nanoparticules C1, C2, C3 forment typiquement des boîtes quantiques ou « quantum dots » (QD) permettant les conversions en longueur d'onde. Des tranchées 40 peuvent être formées pour séparer les différentes zones de dépôt des nanoparticules C1, C2, C3. Alternativement, le module CCM peut par exemple comprendre des filtres colorés C1, C2, C3.

Après formation du ou des modules de conversion de couleur CCM, une couche transparente protectrice et/ou facilitant la manipulation du dispositif optoélectronique par exemple en verre peut être collée sur le ou les modules CCM. Cette couche protectrice est typiquement collée par collage organique sur le ou les modules CCM, afin de préserver les nanoparticules C1, C2, C3. Le substrat de transfert H est ensuite typiquement retiré.

Selon une possibilité, si les plots de contacts 31 n'ont pas été formés préalablement, les plots de contacts 31 sont formés après retrait du substrat de transfert H, typiquement selon les étapes illustrées aux figures 2 à 5. La couche transparente protectrice peut alors avantageusement servir de support structurel après retrait du substrat H pour réaliser les plots 31.

La figure 13 illustre sous forme d'organigrammes un enchaînement d'étapes du procédé selon la présente invention et un enchaînement d'étapes d'un procédé classique, selon l'art antérieur, à titre de comparaison. Il apparaît qu'une multitude d'étapes du procédé selon l'invention, illustré par l'organigramme de gauche sur la figure 13, peuvent être menées préalablement au collage de la partie optique et de la partie de commande. La partie optique et la partie de commande peuvent ainsi être avantageusement traitées séparément, en parallèle l'une de l'autre, avant collage. En particulier, la formation des plots 31 en face avant et la formation des connexions traversantes 130 en face arrière de la partie de commande peuvent être effectuées avant collage de la partie optique sur la partie de commande. Seules les étapes de formation du module de conversion de couleur et les étapes de fin de ligne sont effectuées après collage de la partie optique sur la partie de commande.

Au contraire, selon le procédé classique illustré par l'organigramme de droite sur la figure 13, il est nécessaire de procéder au collage de la partie optique en face avant de la partie de commande, avant de former des plots de contact en face arrière. Il faut ensuite retourner le dispositif pour continuer à effectuer les étapes de formation du module de conversion de couleur et les étapes de fin de ligne. La partie optique et la partie de commande sont ici traitées l'une après l'autre, en série.

Alternativement, lorsque la formation des plots 31 en face avant est effectuée en fin de procédé, après retrait du substrat H, le procédé selon l'invention présente une meilleure compatibilité avec les équipements de fabrication et un collage minéral amélioré.

Comme illustré au travers des exemples précédents, le procédé de fabrication d'un dispositif optoélectronique selon l'invention permet donc avantageusement d'optimiser le temps et les coûts de fabrication d'un tel dispositif, par exemple de type smart pixel. L'invention n'est cependant pas limitée aux modes de réalisations précédemment décrits, la portée de l'invention étant définie par les revendications.

## Revendications

1. Procédé de fabrication d'un dispositif optoélectronique, ledit dispositif optoélectronique comprenant une partie de commande (1) et une partie optiquement active, dite partie optique (2), en empilement selon une direction d'empilement (z), dans lequel :
• la partie de commande (1) comprend au moins :
- un niveau (11) de composants électroniques (110) configuré pour exécuter des fonctions logiques, et
- un niveau (12) d'interconnexions électriques (120) connecté audit niveau (11) de composants électroniques (110) et définissant une première face (101) de la partie de commande (1), dite face avant,
• la partie optique (2) comprenant au moins :
- un niveau (21) de composants optiquement actifs (210) configurés pour émettre ou recevoir un rayonnement lumineux,
- un niveau (22) de connexions électriques (220) connecté audit niveau (21) de composants optiquement actifs (210) et définissant une deuxième face (202) de la partie optique (2), dite face de connexion,
dans lequel la partie de commande (1) et la partie optique (2) sont associées de façon à ce que le niveau (12) d'interconnexions électriques (120) de la partie de commande (1) soit connecté électriquement au niveau (22) de connexions électriques (220) de la partie optique (2),
et dans lequel la partie de commande (1) comprend des connexions (130) dites traversantes s'étendant depuis le niveau (12) d'interconnexion vers une deuxième face (102) de la partie de commande (1) opposée à la première face (101), dite face arrière, ladite face arrière (102) de la partie de commande (1) correspondant à la face de connexion (202) de la partie optique (2), de sorte que le niveau (12) d'interconnexions électriques (120) de la partie de commande (1) est connecté électriquement au niveau (22) de connexions électriques (220) de la partie optique (2) par l'intermédiaire desdites connexions traversantes (130),
ledit procédé comprenant :
• fournir la partie de commande (1) sur un premier substrat (S1), de sorte que la face avant (101) soit exposée,
• coller la partie de commande (1) sur un substrat de transfert (H), au niveau de la face avant (101),
• retirer le premier substrat (S1) de sorte à exposer la face arrière (102) de la partie de commande (1),
• former les connexions électriques traversantes (130) depuis la face arrière (102) jusqu'au niveau (12) d'interconnexions électriques (120) de la partie de commande (1),
• fournir la partie optique (2) sur un deuxième substrat (S2), de sorte que la face de connexion (202) soit exposée,
• coller la face de connexion (202) de la partie optique (2) sur la face arrière (102) de la partie de commande (1),
• retirer le deuxième substrat (S2) de sorte à exposer une face (201) d'émission ou de réception de la partie optique (2).

2. Procédé selon la revendication précédente comprenant en outre une formation de plots de contacts (31) en saillie de la face avant (101) et connectés au niveau (12) d'interconnexions (120), lesdits plots de contact (31) étant destinés à être contactés par des pointes de test.

3. Procédé selon la revendication précédente dans lequel les plots de contact (31) sont formés dans des ouvertures (121) de la face avant (101), lesdites ouvertures (121) débouchant sur des pistes métalliques supérieures (120a, Msup) du niveau (12) d'interconnexions (120).

4. Procédé selon la revendication précédente dans lequel la formation des plots de contact (31) comprend un dépôt pleine plaque d'une couche de germination (300), une étape de lithographie définissant, dans une couche de résine (310), des motifs de contact (M31) à l'aplomb des ouvertures (121) de la face avant (101), un remplissage desdits motifs de contact (M31) par un premier matériau métallique, un retrait de la couche de résine (310) exposant des parties de la couche de germination (300), en dehors des motifs de contact (M31), et un retrait des parties exposées de la couche de germination (300).

5. Procédé selon l'une quelconque des revendications 2 à 4 dans lequel la formation des plots de contacts (31) est effectuée avant collage de la partie de commande (1) sur le substrat de transfert (H),

6. Procédé selon l'une quelconque des revendications 2 à 4 dans lequel la formation des plots de contacts (31) est effectuée après collage de la partie de commande (1) sur le substrat de transfert (H), et après un retrait du substrat de transfert (H),

7. Procédé selon l'une quelconque des revendications 2 à 6 comprenant en outre une étape de test de la partie de commande (1) en connectant des pointes de test sur les plots de contact (31) ou sur des pistes métalliques supérieures (120a, Msup) du niveau (12) d'interconnexions (120).

8. Procédé selon l'une quelconque des revendications 1 à 7 dans lequel le collage de la partie de commande (1) sur le substrat de transfert (H) se fait par intercalation d'une couche (400) entre la face avant (101) de la partie de commande (1) et le substrat de transfert (H), ladite couche (400) étant à base d'un matériau organique ou minéral.

9. Procédé selon l'une quelconque des revendications 1 à 8 comprenant en outre, après retrait du deuxième substrat (S2), une formation de modules de conversion de couleur (CCM) à partir de la face (201) d'émission ou de réception de la partie optique (2), lesdits modules de conversion de couleur (CCM) étant configurés pour modifier une longueur d'onde du rayonnement lumineux émis ou reçu par les composants optiquement actifs (210).

10. Procédé selon la revendication précédente comprenant en outre, après formation des modules de conversion de couleur (CCM), une formation ou un collage d'une couche transparente protectrice sur lesdits modules de conversion de couleur (CCM).

11. Procédé selon l'une quelconque des revendications 1 à 10 dans lequel la formation des connexions électriques traversantes (130) comprend une formation par lithographie et gravure, depuis la face arrière (102), de motifs de vias exposant des pistes métalliques inférieures (120b, Mlow) du niveau (12) d'interconnexions (120), lesdites pistes métalliques inférieures (120b, Mlow) étant de préférence situées du côté des composants électroniques (110), et un remplissage desdits motifs de vias par un deuxième matériau métallique.

12. Procédé selon la revendication précédente dans lequel la face de connexion (202) de la partie optique (2) comprend des deuxièmes zones de contact (231), ledit procédé comprenant en outre une formation de premières zones de contacts (131) sur la face arrière (102) de la partie de commande (1), lesdites premières zones de contact (131) reliant au moins certaines connexions électriques traversantes (130), lesdites premières zones de contact (131) étant configurées pour être assemblées par un collage direct hybride avec les deuxièmes zones de contact (231) de la face de connexion (202) de la partie optique (2).

## Patentansprüche

1. Verfahren zur Herstellung einer optoelektronischen Vorrichtung, wobei die optoelektronische Vorrichtung ein Steuerteil (1) und ein optisch aktives Teil, das sogenannte optische Teil (2), gestapelt in einer Stapelrichtung (z) umfasst, wobei:
• das Steuerteil (1) mindestens Folgendes umfasst:
- eine Ebene (11) mit elektronischen Komponenten (110), die so konfiguriert ist, dass sie logische Funktionen ausführt, und
- eine Ebene (12) mit elektrischen Zwischenverbindungen (120), die mit der Ebene (11) mit elektronischen Komponenten (110) verbunden ist und eine erste Seite (101) des Steuerteils (1), die als Vorderseite bezeichnet wird, definiert,
• das optische Teil (2) mindestens Folgendes umfasst:
- eine Ebene (21) mit optisch aktiven Komponenten (210), die so konfiguriert sind, dass sie eine Lichtstrahlung aussenden oder empfangen,
- eine Ebene (22) mit elektrischen Verbindungen (220), die mit der Ebene (21) mit optisch aktiven Komponenten (210) verbunden ist und eine zweite Seite (202) des optischen Teils (2), die sogenannte Verbindungsseite, definiert, wobei das Steuerteil (1) und das optische Teil (2) so verbunden sind, dass die Ebene (12) mit elektrischen Zwischenverbindungen (120) des Steuerteils (1) elektrisch mit der Ebene (22) mit elektrischen Verbindungen (220) des optischen Teils (2) verbunden ist,
und wobei das Steuerteil (1) sogenannte Durchkontaktierungen (130) umfasst, die sich von der Zwischenverbindungsebene (12) zu einer der ersten Seite (101) gegenüberliegenden zweiten Seite (102), der sogenannten Rückseite, des Steuerteils (1) erstrecken, wobei die Rückseite (102) des Steuerteils (1) der Verbindungsseite (202) des optischen Teils (2) entspricht, so dass die Ebene (12) mit elektrischen Zwischenverbindungen (120) des Steuerteils (1) elektrisch mit der Ebene (22) mit elektrischen Verbindungen (220) des optischen Teils (2) über die Durchkontaktierungen (130) verbunden ist,
wobei das Verfahren Folgendes umfasst:
• Bereitstellen des Steuerteils (1) auf einem ersten Substrat (S1), so dass die Vorderseite (101) freiliegt,
• Aufkleben des Steuerteils (1) auf ein Transfersubstrat (H) an der Vorderseite (101),
• Entfernen des ersten Substrats (S1), so dass die Rückseite (102) des Steuerteils (1) freiliegt,
• Bilden der elektrischen Durchkontaktierungen (130) von der Rückseite (102) bis zur Ebene (12) mit den elektrischen Zwischenverbindungen (120) des Steuerteils (1),
• Bereitstellen des optischen Teils (2) auf einem zweiten Substrat (S2), so dass die Verbindungsseite (202) freiliegt,
• Aufkleben der Verbindungsseite (202) des optischen Teils (2) auf die Rückseite (102) des Steuerteils (1),
• Entfernen des zweiten Substrats (S2), so dass eine Sende- oder Empfangsseite (201) des optischen Teils (2) freiliegt.

2. Verfahren nach dem vorhergehenden Anspruch, das ferner das Bilden von Kontaktstiften (31) umfasst, die von der Vorderseite (101) vorstehen und mit der Ebene (12) von Zwischenverbindungen (120) verbunden sind, wobei die Kontaktstifte (31) dazu bestimmt sind, von Testspitzen kontaktiert zu werden.

3. Verfahren nach dem vorhergehenden Anspruch, wobei die Kontaktstifte (31) in Öffnungen (121) der Vorderseite (101) ausgebildet sind, wobei die Öffnungen (121) in oberen Metallbahnen (120a, Msup) der Ebene (12) mit Zwischenverbindungen (120) münden.

4. Verfahren nach dem vorhergehenden Anspruch, wobei das Bilden der Kontaktstifte (31) das flächendeckende Auftragen einer Keimschicht (300), einen Lithografieschritt, bei dem in einer Harzschicht (310) Kontaktmuster (M31) senkrecht zu den Öffnungen (121) der Vorderseite (101) definiert werden, das Füllen des Kontaktmusters (M31) mit einem ersten metallischen Material, das Entfernen der Harzschicht (310), wodurch Teile der Keimschicht (300) außerhalb des Kontaktmusters (M31) freilegt werden, und das Entfernen der freiliegenden Teile der Keimschicht (300) umfasst.

5. Verfahren nach einem der Ansprüche 2 bis 4, wobei das Bilden der Kontaktstifte (31) vor dem Verkleben des Steuerteils (1) auf das Transfersubstrat (H) durchgeführt wird,

6. Verfahren nach einem der Ansprüche 2 bis 4, wobei das Bilden der Kontaktstifte (31) nach dem Verkleben des Steuerteils (1) auf das Transfersubstrat (H) und nach dem Entfernen des Transfersubstrats (H) durchgeführt wird,

7. Verfahren nach einem der Ansprüche 2 bis 6, ferner umfassend einen Schritt des Testens des Steuerteils (1) durch Verbinden von Testspitzen mit den Kontaktstiften (31) oder mit den oberen Metallbahnen (120a, Msup) der Ebene (12) mit Zwischenverbindungen (120).

8. Verfahren nach einem der Ansprüche 1 bis 7, wobei das Verkleben des Steuerteils (1) auf das Transfersubstrat (H) durch Einfügen einer Schicht (400) zwischen der Vorderseite (101) des Steuerteils (1) und dem Transfersubstrat (H) erfolgt, wobei die Schicht (400) auf einem organischen oder mineralischen Material basiert.

9. Verfahren nach einem der Ansprüche 1 bis 8, das ferner nach dem Entfernen des zweiten Substrats (S2) das Bilden von Farbumwandlungsmodulen (CCM) ausgehend von der Sende- oder Empfangsseite (201) des optischen Teils (2) umfasst, wobei die Farbumwandlungsmodule (CCM) so konfiguriert sind, dass sie eine Wellenlänge der von den optisch aktiven Komponenten (210) gesendeten oder empfangenen Lichtstrahlung ändern.

10. Verfahren nach dem vorhergehenden Anspruch, ferner umfassend nach dem Bilden der Farbumwandlungsmodule (CCM) das Bilden oder Verkleben einer schützenden transparenten Schicht auf den Farbumwandlungsmodulen (CCM).

11. Verfahren nach einem der Ansprüche 1 bis 10, wobei das Bilden der elektrischen Durchkontaktierungen (130) das Bilden durch Lithografie und das Ätzen von Viamustern von der Rückseite (102) aus, wodurch untere Metallbahnen (120b, Mlow) der Ebene (12) mit Zwischenverbindungen (120) freilegt werden, wobei die unteren Metallbahnen (120b, Mlow) vorzugsweise auf der Seite der elektronischen Komponenten (110) liegen, sowie das Füllen der Viamuster mit einem zweiten metallischen Material umfasst.

12. Verfahren nach dem vorhergehenden Anspruch, wobei die Verbindungsfläche (202) des optischen Teils (2) zweite Kontaktbereiche (231) umfasst, wobei das Verfahren ferner das Bilden erster Kontaktbereiche (131) auf der Rückseite (102) des Steuerteils (1) umfasst, wobei die ersten Kontaktbereiche (131) mindestens bestimmte elektrische Durchkontaktierungen (130) verbinden, wobei die ersten Kontaktbereiche (131) so konfiguriert sind, dass sie durch hybrides Direktverkleben mit den zweiten Kontaktbereichen (231) der Verbindungsfläche (202) des optischen Teils (2) verbunden werden.

## Claims

1. Method for manufacturing an optoelectronic device, said optoelectronic device comprising a control part (1) and an optically active part, called optical part (2), stacked according to a stacking direction (z), wherein:
• the control part (1) comprises at least:
- a level (11) of electronic components (110) configured to execute logical functions, and
- a level (12) of electrical interconnections (120) connected to said level (11) of electronic components (110) and defining a first face (101) of the control part (1), called front face,
• the optical part (2) comprising at least:
- a level (21) of optically active components (210) configured to transmit or receive light radiation,
- a level (22) of electrical connections (220) connected to said level (21) of optically active components (210) and defining a second face (202) of the optical part (2), called connection face,
wherein the control part (1) and the optical part (2) are associated so that the level (12) of electrical interconnections (120) of the control part (1) is electrically connected to the level (22) of electrical connections (220) of the optical part (2),
and wherein the control part (1) comprises so-called through connections (130) extending from the interconnection level (12) to a second face (102) of the control part (1) opposite to the first face (101), so-called rear face, said rear face (102) of the control part (1) corresponding to the connection face (202) of the optical part (2), so that the level (12) of electrical interconnections (120) of the control part (1) is electrically connected to the level (22) of electrical connections (220) of the optical part (2) via said through connections (130),
said method comprising:
• providing the control part (1) on a first substrate (S1), so that the front face (101) is exposed,
• gluing the control part (1) onto a transfer substrate (H), at the front face (101),
• removing the first substrate (S1) so as to expose the rear face (102) of the control part (1),
• forming the through electrical connections (130) from the rear face (102) up to the level (12) of electrical interconnections (120) of the control part (1),
• providing the optical part (2) on a second substrate (S2), so that the connection face (202) is exposed,
• gluing the connection face (202) of the optical part (2) onto the rear face (102) of the control part (1),
• removing the second substrate (S2) so as to expose a transmission or reception face (201) of the optical part (2).

2. Method according to the preceding claim, further comprising forming contact pads (31) protruding from the front face (101) and connected at the level (12) of interconnections (120), said contact pads (31) being intended to be contacted by test tips.

3. Method according to the preceding claim, wherein the contact pads (31) are formed in openings (121) of the front face (101), said openings (121) opening onto upper metal tracks (120a, Msup) of the level (12) of interconnections (120).

4. Method according to the preceding claim, wherein the formation of the contact pads (31) comprises a full-wafer deposition of a germination layer (300), a lithography step defining, in a layer of resin (310), contact patterns (M31) vertically in line with the openings (121) of the front face (101), filling of said contact patterns (M31) with a first metal material, a removal of the layer of resin (310) exposing parts of the germination layer (300), outside of the contact patterns (M31), and a removal of the exposed parts of the germination layer (300).

5. Method according to any one of claims 2 to 4, wherein the formation of the contact pads (31) is carried out before gluing of the control part (1) onto the transfer substrate (H).

6. Method according to any one of claims 2 to 4, wherein the formation of the contact pads (31) is performed after gluing of the control part (1) onto the transfer substrate (H), and after a removal of the transfer substrate (H),

7. Method according to any one of claims 2 to 6, further comprising a step of testing the control part (1) by connecting test tips onto the contact pads (31) or onto upper metal tracks (120a, Msup) of the level (12) of interconnections (120).

8. Method according to any one of claims 1 to 7, wherein the gluing of the control part (1) onto the transfer substrate (H) is carried out by interposing a layer (400) between the front face (101) of the control part (1) and the transfer substrate (H), said layer (400) containing an organic or mineral material.

9. Method according to any one of claims 1 to 8, further comprising, after removal of the second substrate (S2), forming colour conversion modules (CCM) from the transmission or reception face (201) of the optical part (2), said colour conversion modules (CCM) being configured to modify a wavelength of the light radiation transmitted or received by the optically active components (210).

10. Method according to the preceding claim, further comprising, after formation of the colour conversion modules (CCM), forming or gluing a protective transparent layer on said colour conversion modules (CCM).

11. Method according to any one of claims 1 to 10, wherein the formation of the through electrical connections (130) comprises forming by lithography and etching, from the rear face (102), patterns of vias exposing lower metal tracks (120b, Mlow) of the level (12) of interconnections (120), said lower metal tracks (120b, Mlow) preferably being located on the electronic components (110) side, and filling said patterns of vias with a second metal material.

12. Method according to the preceding claim, wherein the connection face (202) of the optical part (2) comprises second contact zones (231), said method further comprising forming first contact zones (131) on the rear face (102) of the control part (1), said first contact zones (131) connecting at least some through electrical connections (130), said first contact zones (131) being configured to be assembled by hybrid direct bonding with the second contact zones (231) of the connection face (202) of the optical part (2).
